# EUROPEAN PATENT APPLICATION

(11) **EP 4 564 421 A1**
(43) Date of publication of application: **04.06.2025**
(21) Application number: 23213514.5
(22) Date of filing: 30.11.2023
(51) Int. Cl.: H01L 23/36, H01L 23/31, H01L 23/495

(54) **SEMI-CONDUCTOR DEVICE**

(71) Applicant: Nexperia B.V., 6534 AB Nijmegen (NL)
(72) Inventor: Lee, Wai Wai, Seremban (MY); Hung, Melvin Chew Chee, Seremban (MY); Hing Suan, Eric Cheam, Seremban (MY)
(74) Representative: Pjanovic, Ilija

(57) **Abstract**

There is provided a semi-conductor device. The semi-conductor device comprises: a lead frame; and one or more dies, the one or more dies being secured to the lead frame. The semi-conductor device further comprises: a clip that is secured to at least one of the one or more dies; a first heat sink that is secured to or is formed as part of the clip; and a cover that at least partially encloses the lead frame, the one or more dies, and the clip. A major surface of the cover defines an aperture that extends to the first heat sink. The semi-conductor device further comprises a first metallic layer that is secured to the first major surface of the cover by virtue of a bi-functional adhesive; and a second heat sink that is coupled to the first metallic layer.

## Description

### Field of Invention

The present invention relates to a semi-conductor device, and to a method.

### Background

Semi-conductor devices, such as MOSFETs, are used in a number of applications. Semi-conductor devices may include one or more heat sinks that are provided to increase dissipation of heat from the device.

The present invention seeks to obviate, or at least mitigate, the problems associated with known apparatus, whether identified herein or otherwise.

### Summary

In a first aspect of the invention there is provided a semi-conductor device. The semi-conductor device comprises: a lead frame; and one or more dies, the one or more dies being secured to the lead frame. The semi-conductor device further comprises: a clip that is secured to at least one of the one or more dies; a first heat sink that is secured to or is formed as part of the clip; and a cover that at least partially encloses the lead frame, the one or more dies, and the clip. A major surface of the cover defines an aperture that extends to the first heat sink. The semi-conductor device further comprises a first metallic layer that is secured to the first major surface of the cover by virtue of a bi-functional adhesive; and a second heat sink that is coupled to the first metallic layer.

The device may be a MOSFET.

The first metallic layer may be formed via electroless plating.

Conventionally, in semi-conductor devices, a first (or internal) sink is provided to which a second (or external) heat sink is secured. The first heat sink is secured to or formed as part of the clip. The area of the first heat sink to which the second heat sink is securable is an area of the first heat sink that is exposed through an aperture formed in a cover of such devices.

The first metallic layer of the semi-conductor device of this aspect of the invention serves as a foundation to the second heat sink is secured. Since the first metallic layer is secured to the first major surface of the cover, the area available for contact between the second heat sink and the first metallic layer is greater than that of conventional devices. Increasing the contact area is desirable because the amount of heat that can be dissipated from the second heat sink, and so from the device, is increased. Increasing the amount of heat that is dissipated from the device is desirable because the likelihood of overheating is advantageously reduced. Furthermore, increasing the amount of heat that is dissipated from the device reduces the temperature of the device, in particular during operation. This reduces the resistance between a drain and a source of the device (i.e., the RDS(on) of the device is reduced). Reducing the RDS(on) of the device is desirable because the efficiency of the device is improved as a result.

In use, the device is subject to stresses. The stresses may arise as a result of, for example, temperature fluctuations and/or deformation of the device. Since the contact area between the second heat sink and the first heat sink can be greater than for conventional devices, the stresses that the device is subject to in use are more evenly distributed. This reduces the likelihood of stress concentrations occurring in use. Stress concentrations are undesirable because they can result in, for example, delamination of the device, which can ultimately lead to failure of the device. Therefore, by increasing the potential contact area between the second heat sink and the first heat sink, the device is more robust than conventional devices.

In conventional devices, the area of the internal heat sink to which an external heat sink can be secured is bounded by the cover (i.e., by an aperture that extends through the cover to the internal heat sink). This is because external heat sinks are typically secured to the primary heat sink at an area of the internal heat sink that is exposed through an aperture formed in the cover. Since the first metallic layer is secured to the first major surface of the cover, the area to which the second heat sink can be secured is not bounded at its outer edges in the same manner as conventional devices. This allows the second heat sink to be more readily secured to the first metallic layer, which reduces the likelihood of a defective attachment of the second heat sink. This is as compared to the attachment of external heat sinks in conventional devices.

The first metallic layer and the second heat sink may define an orientation identifying portion.

The phrase "orientation identifying portion" may be understood to refer to a region or regions of the first metallic layer that allows the orientation of the semi-conductor device to be determined.

The orientation identifying portion may be defined by an absence of material.

The orientation identifying portion may be disposed at a periphery of the first metallic layer.

In use, the semi-conductor is assembled onto a printed circuit board. Where the first metallic layer and the second heat sink define an orientation identifying portion, the correct orientation of the device for assembly onto the printed circuit board can be readily determined. Advantageously, this simplifies assembly of the device onto the printed circuit board, allowing for efficient assembly of the device onto the printed circuit board.

A footprint of the first metallic layer and a footprint of the second heat sink may be discontinuous.

Here and throughout this document, the term 'footprint', with regards to a component, may be understood to refer to a plan area of the component when viewed in plan view.

Here and throughout this document, a footprint being discontinuous may be understood to mean that one or more surface irregularities, which preferably are in the form of apertures, are formed within a periphery of the footprint.

Where the footprint of the first metallic layer and a footprint of the second heat sink are discontinuous, a combined exposed surface area of the first metallic layer and the second heat sink is increased. This is as compared to if the footprints of the first metallic layer and of the second heat sink were continuous.

The semi-conductor device may further comprising an array of apertures. Each aperture of the array of apertures may extend from a major surface of the second heat sink to the major surface of the cover.

Each aperture of the array of apertures may be in the form of a blind bore.

Where an array of apertures is provided, the heat dissipation from the device is increased. This further reduces RDS(on) and the likelihood of the device overheating in use.

The second heat sink may define a major surface and a plurality of side walls that extend from the first metallic layer to the major surface. An angle between the first major surface of the cover and each side wall of the plurality of side walls may be at least 30 degrees.

Each side wall of the plurality of side walls may extend substantially perpendicular to the first major surface of the cover.

Here and throughout this document, the angle between the first major surface of the cover and each of the side walls refers to the external angle that is defined between the first major surface of the cover and each of the side walls.

The major surface of the second heat sink may be referred to as an upper surface of the second heat sink, or as a second major surface.

Where the second heat sink is secured to the first metallic layer by a solder layer, the angle between the plurality of sidewalls and the first major surface of the cover being at least 30 degrees advantageously allows easy visual inspection of the quality of the joint that is formed by virtue of the solder layer. This allows for quicker inspection of the joints, and reduces the likelihood that a defective joint is overlooked, thereby improving manufacturing efficiency.

Where the second heat sink is formed by, for example, 3D printing or electroplating, the plurality of sidewalls extending perpendicular to the first major surface of the cover advantageously allows for easy of inspection of the interface between the second heat sink and the first metallic surface. This allows for quicker inspection of the interface, and reduces the likelihood that a defective interface is overlooked, thereby improving manufacturing efficiency.

The second heat sink may extend continuously from the first metallic layer.

The second heat sink may be coupled to the first metallic layer by virtue of an adhesive.

The adhesive may be a solder layer.

A contact area between the first metallic layer and the cover may be at least 50% of an area of the major surface of the cover.

Here, "an area of the major surface of the cover" refers to the entire area of the first major surface of the cover.

The contact area between the first metallic layer and the cover may be at least 75% of the area of the major surface of the cover.

Where a contact area between the first metallic layer and the cover is at least 50% of an area of the major surface of the cover, the heat dissipation from the device can be optimised.

A footprint of the second heat sink may correspond to a footprint of the first metallic layer.

Here and throughout this document, the footprint of the second heat sink corresponding to the footprint of the first metallic layer may be understood to mean that the footprints are substantially identical in shape and size.

Where the footprint of the second heat sink corresponds to a footprint of the first metallic layer, heat dissipation from the device is optimised.

In a second aspect of the invention there is provided a method that comprises providing a semi-conductor device. The semi-conductor device comprises: a lead frame; one or more dies, the one or more dies being secured to the lead frame; a clip that is secured to at least one of the one or more dies; a first heat sink that is secured to or is formed as part of the clip; a cover that at least partially encloses the lead frame, the one or more dies, and the clip. An outer surface of the cover defines a major surface. The cover comprises an aperture that extends to the first heat sink. The method further comprises: applying a bi-functional adhesive layer to the first major surface of the cover; applying a catalytic layer to the bi-functional adhesive layer; forming a first metallic layer on the catalytic layer such that the first metallic layer is secured to the bi-functional adhesive layer; and coupling a second heat sink to the first metallic layer.

It will be appreciated that the advantages associated with the first aspect of the invention apply to this aspect mutatis mutandis.

The method may further comprise, prior to applying the bi-functional adhesive, masking one or more regions of the first major surface of the cover using a masking device. The masking device may be configured to prevent adherence of the bi-functional adhesive to the one or more regions of the first major surface of the cover that the masking device masks.

The geometry of the masking device may be such that the first metallic layer defines an orientation identifying portion.

The geometry of the masking device may be such that the bi-functional adhesive is applied to the first major surface of the cover in a discontinuous manner.

The second heat sink may be coupled to the first metallic layer by printing the second heat sink onto the first metallic layer.

The second metallic layer may be formed via electroplating.

The second heat sink may be coupled to the first metallic layer by virtue of an adhesive.

The first metallic layer may be formed using electroless plating.

Features disclosed in relation to one aspect of the invention can be combined with another aspect of the invention as appropriate.

### Brief Description of the Drawings

Embodiments of the present invention will now be described with reference to the accompanying drawings, in which:
Figure 1 shows a part of semi-conductor device according to an embodiment of the present invention;
Figure 2 shows the semi-conductor device of Figure 1 with a cover in place;
Figure 3 shows the semi-conductor device of Figures 1 and 2 with a second heat sink in place;
Figures 4 and 5 show a semi-conductor device of the preceding Figures during manufacture of the device; and
Figures 6 and 7 show alternative embodiments of the semi-conductor device.

### Detailed Description

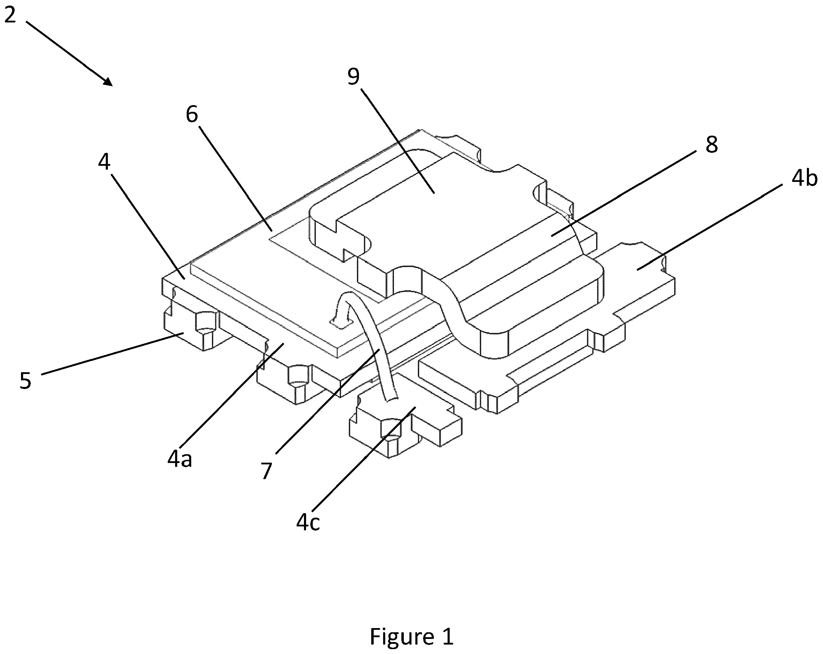

Figure 1 shows a semiconductor device 2. The semi-conductor device 2 comprises a lead frame 4. The semi-conductor device 2 comprises a die 6. The die 6 is secured to the lead frame 4. The semi-conductor device 2 comprises a clip 8. The semi-conductor device comprises a wire 7. The semi-conductor device 2 further comprises a cover (not shown in Figure 1 for clarity).

The lead frame 4 serves as a base of the semi-conductor device 2 to which other components of the device are attached. In the depicted embodiment, the lead frame 4 comprises a first portion 4a, a second portion 4b, and a third portion 4c. However, in some, non-depicted, embodiments, the lead frame 4 may comprise any suitable number of portions. For example, the lead frame 4 may comprise only a single portion. The lead frame 4 comprises a plurality of connection points 5 (only one of which is labelled in Figure 1). The plurality of connection points 5 allow the semiconductor device 2 to be connected to an external circuit (not shown). The lead frame 4 is manufactured from a conductive material such as copper (including a copper alloy).

The die 6 is secured to the lead frame 4. The die 6 is secured to the lead frame 4 by virtue of an adhesive, such as a solder layer. The die 6 may be a single component or may comprise multiple constituent components. The die 6 is made of a semi-conducting material. The die 6 is generally rectangular, but may be any other suitable shape. The die 6 is plate like in shape.

The clip 8 electrically and mechanically couples the second portion 4b of the lead frame 4 to the die 6. The clip 8 therefore also electrically and mechanically couples the first portion 4a of the lead frame 4 to the second portion 4b of the lead frame 4.

The device 2 comprises a first heat sink 9. In the depicted embodiment, the heat sink 9 is integrally formed with the clip 8. However, the heat sink 9 may be separately formed from the clip 8 and secured to the clip 8 by virtue of, for example, an adhesive such as a solder layer. The first heat sink 9 is provided to increase the rate at which heat dissipates from the device 2.

The wire 7 electrically couples the first portion 4a of the lead frame 4 to the third portion 4c of the lead frame 4. The wire 7 may be attached to the lead frame 4 by, for example, ultrasonic welding. Other methods for securing the wire 7 to the lead frame 4 may be used, however. In some embodiments, the clip 8 may electrically couple the first portion 4a of the lead frame 4 to the third portion 4c of the lead frame 4.

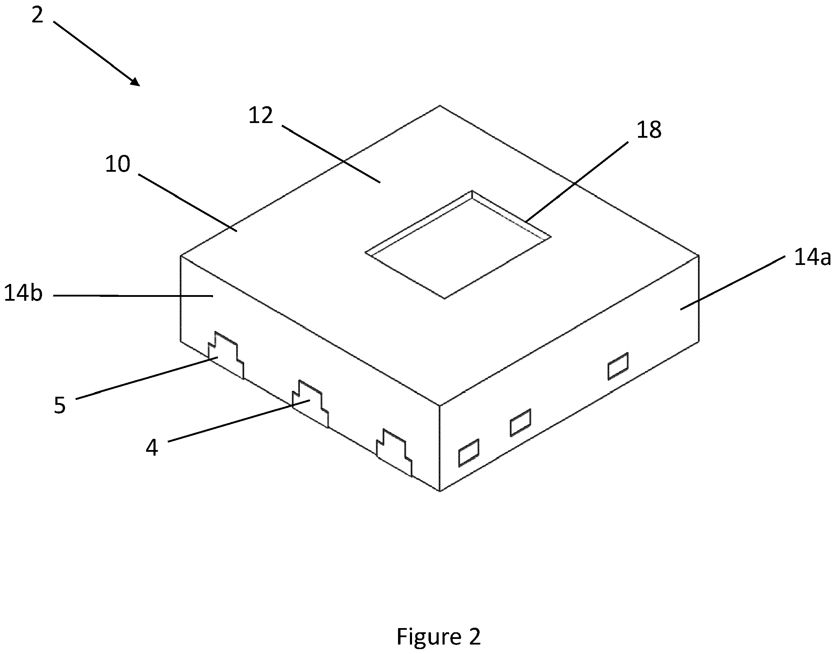

Figure 2 shows the device 2 with the cover 10 in place. As will be discussed below, a second heat sink (not shown in Figure 2) is secured to the cover 10. The cover 10 at least partially encloses the lead frame 4, the die, and the clip 8 (the die is not visible in Figure 2 - they are within the cover 10). In the depicted embodiment, the cover 10 encapsulates the remaining components of the device 2 (i.e., the lead frame 4, the die 6, and the clip 8). The plurality of connection points 5 of the lead frame 4 extend through the cover 10. This allows the connection points 5 to be connected to the external circuit (not shown). The cover 10 may also be referred to as an isolator, a casing, or an encapsulant. The cover 10 may be made from any suitable electrically isolating material, such as an epoxy.

The cover 10 defines a first major surface 12. The first major surface 12 may be described as an upper surface of the cover 10 and/or of the device 2. The first major surface 12 is an outer surface of the cover 10. The cover 10 defines a plurality of side surfaces 14a, 14b (only two of which are visible in Figure 2). The side surfaces 14a, 14b are outer surfaces of the cover 10. Each side surface of the plurality of side surfaces 14a, 14b adjoin the first major surface 12 of the cover 10. Each side surface of the plurality of side surfaces 14a, 14b adjoin a periphery of the first major surface 12 of the cover 10. The plurality of connection points 5 extend through the side surface 14b. The first major surface 12 defines an aperture 18. The aperture 18 extends to the first heat sink 9.

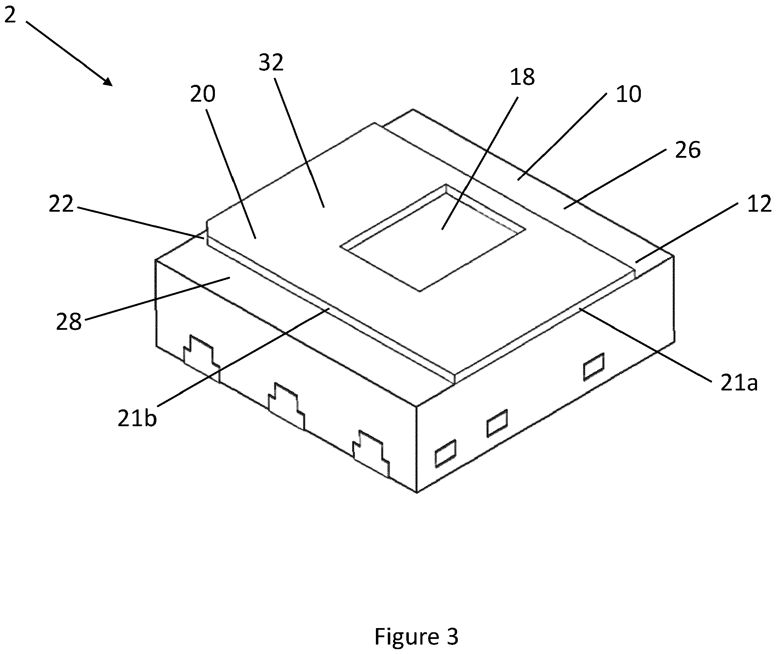

Figure 3 shows the device 2 with a second heat sink 20 in place. The second heatsink is coupled to a first metallic layer (not visible in Figure 3). The first metallic layer is secured to the first major surface 12 of the cover 10 by virtue of a bi-functional adhesive. The first metallic layer will be discussed in more detail below. The second heatsink 20 further increases the rate at which heat dissipates from the device 2. The second heatsink 20 is formed of a metallic material, preferably copper or a copper alloy. As will be discussed further below, the second heat sink 20 may be formed via 3D printing or electroplating. Alternatively, the second heat sink 20 may be secured to the first metallic layer by virtue of a solder layer (not shown in Figure 3).

The second heat sink 20 comprises a plurality of side walls 21a, 21b (only two of which are visible in Figure 3). The second heat sink 20 comprises a major surface 32. The major surface 32 of the second heat sink 20 may be referred to as an upper surface of the second heat sink 20. The plurality of side walls 21a, 21b extend about a periphery of the major surface 32. The plurality of side walls 21a, 21b each extend from the first metallic layer to the major surface 32. The plurality of side walls 21a, 21b extend perpendicular to the first major surface 12 of the cover 10. Where the second heat sink 20 is secured to the first metallic layer by a solder layer, the plurality of sidewalls 21a, 21b extending perpendicular to the first major surface 12 of the cover 10 advantageously allows easy visual inspection of the quality of the joint that is formed by virtue of the solder layer. This allows for quicker inspection of the joints, and reduces the likelihood that a defective joint is overlooked, thereby improving manufacturing efficiency. In some embodiments, the angle between the first major surface 12 of the cover 10 and each of the plurality of side walls 21a, 21b may be at least 30 degrees, measured from the horizontal (i.e. along the direction of the first major surface 12 of the cover 20). This angle is preferably 90 degrees as the device would then be suitable for singulation through common separation methods, such as punch-out or punch-in, and more preferably between 85 and 95 degrees to account for tolerances when using such singulation techniques. The angle of the side walls 21a, 21b applies to all embodiments disclosed herein. This angle may be chosen based on, for example, a desired heat dissipation rate from the second heat sink 20. Here and throughout this document, the angle between the first major surface 12 of the cover 10 and each of the side walls 21a, 21b refers to the external angle that is defined between the first major surface 12 of the cover 10 and each of the side walls 21a, 21b.

The second heatsink 20 defines an orientation identifying portion 22. The orientation identifying portion 22 allows the orientation of the device 2 to be readily determined. This is particularly useful during assembly of the device 2 into an external circuit. In the depicted embodiment, the orientation identifying portion is in the form of a notch, in particular a chamfered notch. However, in other embodiments, the orientation identifying portion 22 may take any other suitable form. In some embodiments, the orientation identifying portion need not be provided.

Manufacture of the device 2 will now be discussed with reference to Figures 2 to 4. Referring first to Figure 2. A masking device is used to mask at least part of to the first major surface 12 of the cover 10. The masking device is also used to mask (i.e., cover) the plurality of side surfaces 14a, 14b of the cover 10, and to an underside (not visible in Figure 2) of the device. The underside of the device is generally opposed to the first major surface 12 of the cover 10. The masking device is configured to prevent the bi-functional adhesive from contacting the region or regions of the cover 10 that it masks. In some embodiments, discussed below, the masking device need not be used to one or more of the surfaces or regions of the cover 10. The geometry of the masking device determines the final geometry of the second heat sink 20, as will be discussed in more detail below. Where the orientation identifying portion is to be provided, the masking device defines the geometry necessary for the first metallic layer to define the orientation identifying portion once the first metallic layer is formed on the device. For example, the masking device may mask a portion of the first major surface 12 of the cover 10 that corresponds to a footprint of the orientation identifying portion.

A bi-functional adhesive layer is then applied to the first major surface 12 of the cover 10. The bi-functional adhesive may be a compound suitable for adhering to both the first major surface 12 of the cover 10 and the heatsink 20. The bi-functional adhesive comprises a first functional group capable of (reacting and) bonding with the first major surface 12 of the cover 10 and a second functional group capable of (reacting and) bonding with the heatsink 20 through a metallic layer. The compound is preferably an organic polymer. The bi-functional adhesive may be applied by either spraying the cover 10 with the bi-functional adhesive. Alternatively, the device 2 may be submerged in a bath of the bi-functional adhesive. The masking device prevents the bi-functional adhesive from contacting, and therefore from adhering, to the first major surface 12 of the cover 10 in the region or regions that it masks. In some embodiments, discussed below, the masking device results in the bi-functional adhesive being applied in a discontinuous manner. Therefore, the bi-functional adhesive layer may be formed of multiple, separate, parts.

Next, a catalytic layer is applied to the device 2. In particular, the catalytic layer is applied to the bi-functional adhesive. To apply the catalytic layer to the bi-functional adhesive, the device 2 is submerged in a bath of a solution that includes the catalyst that is to form the catalytic layer. The catalyst activates the surface of the bi-functional adhesive layer.

Alternatively, the catalytic layer may be sprayed on to the device 2 instead of submerging the device in the bath. The catalytic layer does not adhere directly to the cover 10.

The bi-functional adhesive adheres to only the region or regions of the cover 10 to which the masking device allows (i.e., to the region or regions that are not covered by the masking device). As mentioned above, the catalytic layer does not adhere directly to the cover. The catalytic layer adheres to the bi-functional adhesive layer. The catalytic layer forms the foundation of the first metallic layer. It will therefore be apparent that the geometry of the masking device (where provided) influences the geometry of the first metallic layer. Put another way, the geometry of the masking device defines the negative, or empty, space of the first metallic layer.

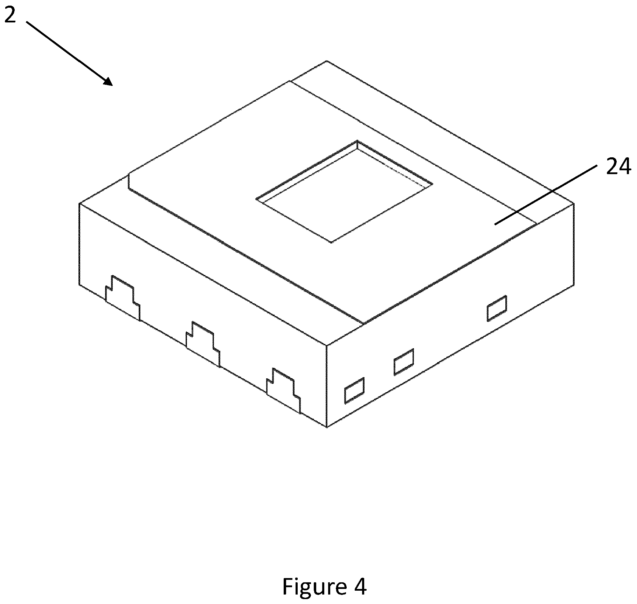

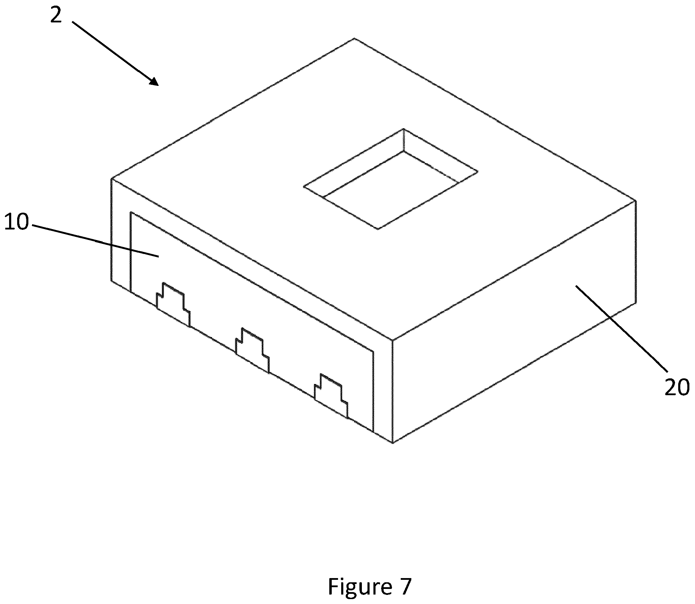

Referring to Figure 4, the first metallic layer 24 is then formed. The first metallic layer 24 is formed on the catalytic layer. This secures the first metallic layer 24 to the bi-functional adhesive layer, and therefore to the first major surface 12 of the cover 10. The first metallic layer 24 is formed using electroless plating. Preferably, a contact area between the first metallic layer and the cover 10 is at least 50% of an area of the first major surface 12 of the cover 10. The contact area between the first metallic layer and the cover 10 may be at least 75% of an area of the first major surface 12 of the cover 10. The contact area between the first metallic layer and the cover 10 may be chosen based on, for example, the desired rate at which heat is to dissipate from the device. This may be dependent upon, for example, the environment in which the device is intended to be used. Here, an area of the first major surface 12 of the cover 10 refers to the entire area of the first major surface 12 of the cover 10. In some embodiments, such as that shown in Figure 7, the second heat sink 20 may be coupled to one or more of the side surfaces 14a, 14b of the cover 10. This further increases the surface area of the second heat sink 20, which increases the rate at which heat dissipates from the device 2.

Referring to Figure 3, the second heat sink 20 is then coupled to the first metallic layer (not visible in Figure 3). The second heat sink 20 may be coupled to the first metallic layer such that the second heat sink 20 extends continuously from the first metallic layer, such as by virtue of forming the second heat sink 20 by 3D printing. The footprint of the second heat sink 20 may correspond to the footprint of the first metallic layer. Alternatively, the second heat sink 20 may be separately formed and coupled to the first metallic layer by virtue of an adhesive. An appropriate adhesive may be a solder layer disposed between the first metallic layer and the second heat sink 20. In some embodiments, the second heatsink may be formed via electroplating. Where the second heatsink is electroplated or 3D printed onto the first metallic layer, the second heat sink 20 may be said to extend continuously from the first metallic layer. 3D printing of the second heat sink 20 is preferred because it allows the second heat sink 20 to be produced quicker than where the second heat sink 20 is formed by electroplating.

Since the first metallic layer is formed on the first major surface 12 of the cover 10, the area to which the second heat sink 20 can be coupled is increased as compared to conventional devices. This improves heat dissipation from the device 2, which decreases the likelihood of overheating of the device 2. In addition, the stresses that the device 2 is subject to in use are better distributed, which reduces the likelihood of delamination of the device 2.

Where the second heat sink 20 is separately formed from the first metallic layer and secured to the first metallic layer using a solder layer, the device 2 is then heated. This process is referred to as 'reflow'.

The device 2 may then be connected to an external circuit in a conventional manner.

In the embodiment shown in Figure 3 the first major surface 12 of the cover 10 comprises a first masked portion 26 and a second masked portion 28. The first metallic layer also defines an orientation identifying the portion 22. The first masked portion 26 and the second masked portion 28 are disposed along opposed portions of the periphery of the first major surface 12. The first masked portion 26 and the second masked portion 28 adjoin respective side surfaces of the cover 10.

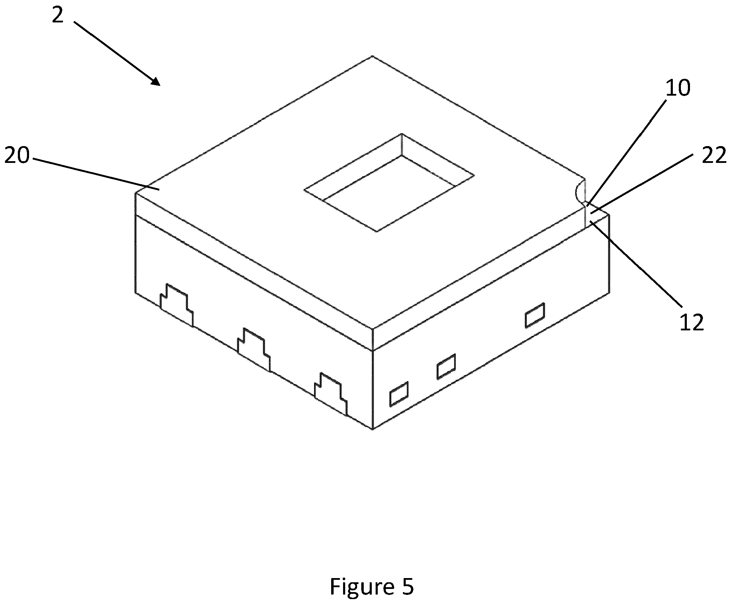

In an alternative embodiment shown in Figure 5, the first major surface 12 of the cover 10, and therefore the first metallic layer, only defines the orientation identifying portion 22. That is to say, the first metallic layer and the second heat sink 20 extend to the periphery of the first major surface 12 of the cover 10, with the exception of the region that defines the orientation identifying portion. In this embodiment, the side surfaces 14a, 14b of the cover have still been masked by the masking device such that the first metallic layer and the second heat sink 20 are not coupled to the side surfaces 14a, 14b. However, as for any embodiment, this need not be the case.

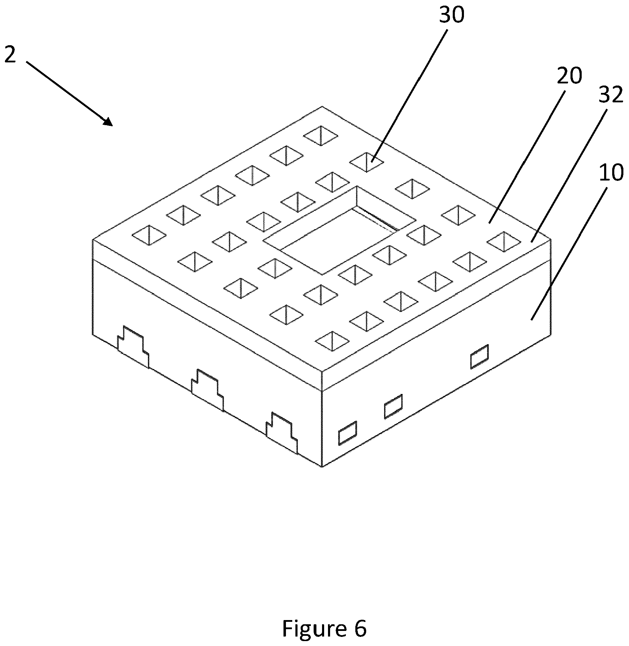

In the embodiment shown in Figure 6, the second heat sink 20 comprises a plurality of apertures 30 (only one of the apertures of the array of apertures has been labelled in Figure 6). The plurality of apertures 30 are provided by virtue of the masking device. When applying the bi-functional adhesive, the masking device masks the regions of the first major surface (not visible in Figure 6) of the cover 10 corresponding to the apertures 30. However, the plurality of apertures 30 may be provided during 3D printing. The plurality of apertures 30 are provided in an array. However, the apertures may be provided in any suitable manner. Each aperture of the plurality of apertures 30 are square in cross-section. However, the apertures may be any suitable shape in cross section. Each aperture of the plurality of apertures 30 extend from the major surface 32 of the second heat sink 20 to the major surface (not visible in Figure 6) of the cover 10. The second heat sink 20 being provided with a plurality of apertures 30 advantageously increases the surface area of the second heat sink 20, which further increases the rate at which heat is dissipated from the device 2. In other, non-depicted embodiments, a footprint of the second heatsink, and therefore of the first metallic layer, may define any other suitable discontinuous geometry. For example, the first metallic layer and the second heat sink may be comprised of a plurality of strips that extend along the first major surface 12 of the cover 10. Here and throughout this document the term footprint with regard to a component may be understood to refer to a planned area of the component. In addition, here and throughout this document a footprint being discontinuous may be understood to mean that one or more surface irregularities, which preferably are in the form of apertures, are formed within a periphery of the footprint.

In the embodiment shown in Figure 7, the first metallic layer and the second heat sink 20 are secured to a plurality of the side surfaces of the cover 10. This increases the rate at which heat dissipated from the device 2.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A semi-conductor device comprising:
a lead frame;
one or more dies, the one or more dies being secured to the lead frame;
a clip that is secured to at least one of the one or more dies;
a first heat sink that is secured to or is formed as part of the clip;
a cover that at least partially encloses the lead frame, the one or more dies, and the clip, wherein a major surface of the cover defines an aperture that extends to the first heat sink;
a first metallic layer that is secured to the first major surface of the cover by virtue of a bi-functional adhesive; and
a second heat sink that is coupled to the first metallic layer.

2. The semi-conductor device of claim 1, wherein the first metallic layer and the second heat sink define an orientation identifying portion.

3. The semi-conductor device of any preceding claim, wherein a footprint of the first metallic layer and a footprint of the second heat sink are discontinuous.

4. The semi-conductor device of claim 3 or claim 4, further comprising an array of apertures, each aperture of the array of apertures extending from a major surface of the second heat sink to the major surface of the cover.

5. The semi-conductor device of any preceding claim, wherein the second heat sink defines a major surface and a plurality of side walls that extend from the first metallic layer to the major surface, and wherein an angle between the first major surface of the cover and each side wall of the plurality of side walls is at least 30 degrees, optionally wherein each side wall of the plurality of side walls extends substantially perpendicular to the first major surface of the cover.

6. The semi-conductor device of any preceding claim, wherein the second heat sink extends continuously from the first metallic layer, or wherein
the second heat sink is coupled to the first metallic layer by virtue of an adhesive.

7. The semi-conductor device of any preceding claim, wherein a contact area between the first metallic layer and the cover is at least 50% of an area of the major surface of the cover.

8. The semi-conductor device any preceding claim, wherein a footprint of the second heat sink corresponds to a footprint of the first metallic layer.

9. A method comprising:
providing a semi-conductor device, the semi-conductor device comprising:
a lead frame;
one or more dies, the one or more dies being secured to the lead frame;
a clip that is secured to at least one of the one or more dies;
a first heat sink that is secured to or is formed as part of the clip;
a cover that at least partially encloses the lead frame, the one or more dies, and the clip, wherein an outer surface of the cover defines a major surface, and wherein the cover comprises an aperture that extends to the first heat sink;
applying a bi-functional adhesive layer to the first major surface of the cover;
applying a catalytic layer to the bi-functional adhesive layer;
forming a first metallic layer on the catalytic layer such that the first metallic layer is secured to the bi-functional adhesive layer; and
coupling a second heat sink to the first metallic layer.

10. The method of claim 8, further comprising prior to applying the bi-functional adhesive, masking one or more regions of the first major surface of the cover using a masking device, the masking device being configured to prevent adherence of the bi-functional adhesive to the one or more regions of the first major surface of the cover that the masking device masks.

11. The method of claim 10 or claim 11, wherein the geometry of the masking device is such that the first metallic layer defines an orientation identifying portion.

12. The method of claim 10, wherein the geometry of the masking device is such that the bi-functional adhesive is applied to the first major surface of the cover in a discontinuous manner.

13. The method of any of claims 9 to 12, wherein the second heat sink is coupled to the first metallic layer by printing the second heat sink onto the first metallic layer; optionally wherein
the second metallic layer is formed via electroplating.

14. The method of any of claims 9 to 12, wherein the second heat sink is coupled to the first metallic layer by virtue of an adhesive.

15. The method of any of claims 9 to 14, wherein the first metallic layer is formed using electroless plating.
